# FASCICULE DE BREVET EUROPEEN

(11) **EP 0 299 853 B1**
(45) Date de publication et mention de la délivrance du brevet: **06.10.1993**
(21) Numéro de dépôt: 88401777.3
(22) Date de dépôt: 07.07.1988
(51) Int. Cl.: H01L 27/10, H01L 21/28, H01L 29/60

(54) **Procédé de fabrication d'une cellule de mémoire**
Verfahren zum Herstellen einer Speicherzelle
Process for producing a memory cell

(30) Priorité: 10.07.1987 FR 8709844
(43) Date de publication de la demande: 18.01.1989
(73) Titulaire: COMMISSARIAT A L'ENERGIE ATOMIQUE Etablissement de Caractère Scientifique Technique et Industriel, 75752 Paris Cedex 15 (FR)
(72) Inventeur: Jeuch, Pierre, F-38170 Seyssins (FR)
(74) Mandataire: Mongrédien, André

(56) Documents cités:
- EP-A- 0 055 608
- EP-A- 0 258 141
- IBM TECHNICAL DISCLOSURE BULLETIN, vol. 29, no. 3, août 1986, page 1328, Armonk, New York, US; "Method to produce sizes in openings in photo images smaller than lithographic minimum size"
- IBM TECHNICAL DISCLOSURE BULLETIN, vol. 26, no. 9, février 1984, pages 4587-4589, New York, US; C. JOHNSON, Jr. et al.: "Method for making submicron dimensions in structures using sidewall image transfer techniques"
- K. KUROSAWA, "A new bird's beak free field isolation technology for VLSI devices", IEDM, 1981, page 384; & JP-A-56 50509 (April 1981)

## Description

La présente invention a pour objet un procédé de fabrication d'une cellule de mémoire intégrée. Elle s'applique en particulier dans le domaine de la fabrication de circuits mémoires intégrés de type ROM ou EPROM, en technologie MOS.

Une mémoire intégrée est un circuit intégré comprenant une partie mémoire proprement dite, appelée cellule mémoire, formée de plusieurs points mémoire connectés électriquement entre eux, et de circuits périphériques servant à commander les points mémoires.

L'invention a pour objet uniquement la fabrication de la partie mémoire proprement dite.

Les cellules mémoires les plus modernes, permettant la mémorisation de 10⁶ éléments binaires, présentent aujourd'hui des surfaces de 20 à 25 µm² dans une technologie de 1,2 µm, c'est-à-dire dans laquelle les bandes et les espaces les plus petits mesurent 1,2 µm. La surface d'une mémoire est donc d'environ 14 à 17 fois celle du carré élémentaire de la lithographie (1200 x 1200 nm²).

La demande de brevet EP-A-0 055 608 concerne un procédé de réalisation de mémoires intégrées de type ROM ou EPROM. Le but recherché est d'obtenir un parfait aplomb entre l'oxyde de champ et l'un des bords de grilles côté drain (ou source). Le procédé consiste à utiliser des résines de masquage pour définir les grilles et, après avoir défini les grilles, à utiliser un masque de résine qui protège la région placée entre deux rangées de grilles, afin de graver la couche d'oxyde de silicium servant à réaliser l'oxyde de champ et qui est non protégée par la résine. L'un des bords de l'empilement de couches formant chaque grille sur l'oxyde de champ définit l'aplomb lors de la gravure de la couche formant cet oxyde de champ.

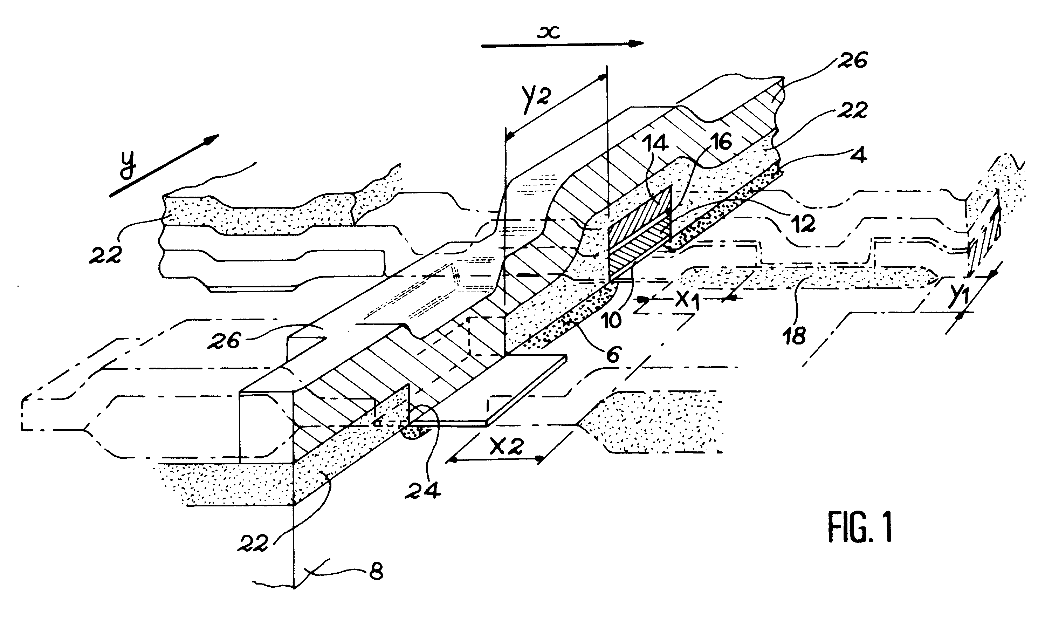

Sur la figure 1, on a représenté schématiquement en perspective une cellule mémoire connue de type EPROM, c'est-à-dire une cellule de mémoire électriquement programmable à lecture seulement et effaçable par un rayonnement ultraviolet.

Comme représenté sur la figure 1, un point mémoire est formé d'un transistor comprenant une source 4 et un drain 6 réalisés dans un substrat 8 semiconducteur monocristallin en silicium ; la source et le drain présentent des conductivités inverses de celles du substrat.

Le transistor comprend en outre un isolant de grille 10, généralement en oxyde de silicium, sur lequel sont empilées une première grille 12 et une seconde grille 14, généralement réalisées en silicium polycristallin dopé au phosphore. Ces deux grilles sont séparées par une fine couche d'isolant 16, généralement en oxyde de silicium.

La première grille 12 est une grille flottante et la seconde grille 14 est la grille de commande du point mémoire.

Ce point mémoire est isolé électriquement, au moyen d'un oxyde de champ 18 réalisé par oxydation localisée et superficielle du substrat, des autres points mémoire ainsi que des circuits périphériques de commande de ce point mémoire.

L'ensemble d'une cellule mémoire est recouvert d'une couche épaisse isolante 22, généralement en oxyde de silicium dans laquelle sont réalisés les trous de contact électriques des sources et des drains tels que 24. Les connexions électriques entre les sources et les drains des différents points mémoire et/ou les différents circuits périphériques de commande sont assurées par une couche conductrice 26, généralement en aluminium, déposée sur la couche isolante 22 et gravée de façon appropriée.

Les connexions électriques entre les grilles de commande des différents points mémoire sont définies en même temps que les grilles de commande 14 et dans la même couche de silicium polycristallin.

De plus en plus, on cherche à diminuer la dimension des circuits intégrés, et en particulier des mémoires, en vue d'augmenter leur densité d'intégration. Malheureusement, dans les mémoires actuellement connues deux facteurs limitent la réduction des dimensions de la cellule mémoire.

Le premier facteur est le recouvrement entre la grille flottante 12 et l'oxyde de champ 18 ; un débordement X1 de la grille flottante 12 au-dessus de l'oxyde de champ 18 et un débordement Y1 de l'oxyde de champ 18 par rapport à la grille flottante 12 sont nécessaires à cause de l'imprécision de superposition des différentes couches constituant les points mémoires et des masques de lithographie, nécessaires pour la gravure des différentes couches. Ces débordements sont respectivement dans la direction X des lignes de mots (ou connexions des grilles) de la cellule mémoire, et dans la direction Y des canaux des points mémoire, qui est perpendiculaire à la direction X.

Le second facteur est la nécessité de prévoir des gardes isolantes autour des trous de contact de la ligne d'éléments binaires, c'est-à-dire autour des trous de contacts des drains des points mémoire. Une garde isolante X2 est prévue dans la direction X entre le contact de drain et l'oxyde de champ 18 et une autre garde isolante Y2 est prévue dans la direction Y entre le contact de drain et les grilles 12, 14.

La diminution des dimensions lithographiques ne s'accompagnant pas généralement d'une amélioration proportionnelle dans les précisions de superposition des différents niveaux, notamment de masquages lithographiques, les facteurs de limitation mentionnés ci-dessus vont être de plus en plus pénalisants pour l'augmentation de la densité d'intégration des mémoires.

Des procédés d'auto-alignement ou d'auto-positionnement évitant le recouvrement entre la grille flottante et l'oxyde de champ et/ou les gardes isolantes autour des trous de contact deviennent donc nécessaires pour les générations futures de mémoires.

L'article para dans IBM Technical Disclosure Bulletin, vol. 26, no. 9, février 1984, pages 4587-4589, New York, décrit un procédé de fabrication de grilles dans lequel le masque utilisé lors de la gravure permettant de definir la largeur de la grille est constitué par un espaceur.

La présente invention a justement pour objet un procédé de fabrication d'une cellule mémoire permettant en particulier de remédier à ces différents inconvénients. La cellule mémoire présente notamment un auto-alignement ou auto-positionnement intégral de tous les éléments constitutifs de ses points mémoires, ce qui conduit à une surface de mémoire ne représentant que quatre à cinq fois la surface lithographique minimale. En outre, la cellule mémoire selon l'invention n'est pas limitée à une technologie micronique et peut être réalisée selon une technologie submicronique.

De manière précise, l'invention a pour objet un procédé de fabrication d'une cellule de mémoire intégrée sur un substrat semiconducteur comportant une matrice de points mémoire isolés électriquement les uns des autres, chaque point mémoire comprenant un drain, une source, une grille et une ligne de commande de grille, ledit procédé comprenant les étapes suivantes :
a) une première étape de définition des grilles des points mémoire et de leur ligne de commande comprenant les opérations suivantes :
   - a1) réalisation d'un empilement de matériaux dont l'un au moins est conducteur et à la forme de premières bandes parallèles, alignées suivant une première direction Y, pour réaliser une grille de points mémoire et dont un autre au moins est constitué d'une couche conductrice pour réaliser les lignes de commande de grilles,
   - a2) réalisation d'un ensemble de deuxièmes bandes parallèles, alignées suivant une seconde direction X perpendiculaire à la première direction Y, lesdites bandes comprenant au moins une couche de matériau isolant,
   - a3) réalisation d'espaceurs sur chaque flanc desdites deuxièmes bandes, lesdits espaceurs formant des bandes suivant ladite seconde direction X, lesdites grilles étant définies par les zones de superposition desdits espaceurs et desdites premières bandes, et lesdites lignes de commande étant définies par lesdits espaceurrs,
b) une deuxième étape de réalisation des sources des points mémoire comprenant les opérations suivantes :
   - b1) gravure des couches non protégées par les espaceurs ou par les matériaux constituants les deuxièmes bandes,
   - b2) dopage du substrat mis à nu par ladite gravure,
   - b3) dépôt d'un matériau isolant sur les zones dopées,
c) une troisième étape de réalisation des drains des points mémoire comprenant les opérations suivantes :
   - c1) élimination par gravure des matériaux constituant les deuxièmes bandes,
   - c2) élimination par gravure complète ou partielle des matériaux constituant l'empilement qui a été mis à nu lors de la gravure précédente,
   - c3) dopage du substrat dans les régions gravées dans l'étape précédente,
   - c4) isolation des flancs côté drain des grilles qui ont été mis à nu par les gravures précédentes,
d) une quatrième étape de réalisation de lignes conductrices parallèles, alignées suivant la première direction, lesdites lignes conductrices étant reliées électriquement aux drains des points mémoire.

Selon l'invention, les sources et les drains des points mémoire sont réalisés au cours de deux étapes successives indépendantes. Ceci permet d'effectuer des dopages différents pour les sources et pour les drains. Par ailleurs, la largeur des grilles est définie dans la première étape du procédé par un masque constitué par des espaceurs, ce qui présente l'avantage de permettre de réaliser facilement des grilles de largeur submicronique.

De manière préférée, les espaceurs réalisés au cours de la première étape sont obtenus par dépôt d'une couche de matériau isolant sur la surface totale du substrat semiconducteur, suivie d'une gravure anisotrope de ladite couche isolante sur toute son épaisseur.

De manière préférée, le matériau de l'empilement dans lequel les grilles seront obtenues est réalisé sous forme de premières bandes par oxydation localisée d'une couche de silicium polycristallin dopé à travers un masque, les zones oxydées constituant un ensemble de troisièmes bandes parallèles.

De manière avantageuse, l'isolation du flanc côté drain des grilles au cours de la troisième étape est obtenue par un espaceur réalisé dans un matériau isolant.

Selon une caractéristique secondaire, ledit espaceur est obtenu par dépôt d'une couche de matériau isolant sur la surface totale du substrat semiconducteur, puis gravure anisotrope de ladite couche de matériau isolant.

De manière préférée, pour la fabrication d'une cellule de mémoire EPROM, l'empilement est constitué par une première couche d'un oxyde de grille, une deuxième couche de matériau conducteur, dans laquelle seront gravées les grilles, dites grilles flottantes, des points mémoire, lesdites première et seconde couches formant lesdites premières bandes, une troisième couche de matériau isolant, une quatrième couche de matériau conducteur, dans laquelle seront gravées les lignes de commande des points mémoire formant aussi les grilles de commande des points mémoire, et une cinquième couche de matériau isolant.

De même, pour la fabrication d'une cellule de mémoire ROM, l'empilement est constitué préférentiellement par une première couche d'un oxyde de grille, une deuxième couche de matériau conducteur, dans laquelle seront gravées les grilles des points mémoire, lesdites première et seconde couches formant lesdites premières bandes, une troisième couche de matériau conducteur dans laquelle seront gravées les lignes de commande des points mémoire, et une quatrième couche de matériau isolant.

Les caractéristiques et avantages de l'invention ressortiront mieux de la description qui va suivre, donnée à titre illustratif mais non limitatif, en référence aux dessins annexés, sur lesquels :
- la figure 1, déjà décrite, représente schématiquement en perspective une cellule mémoire EPROM connue,
- la figure 2 représente schématiquement en vue de dessus la disposition des points mémoire d'une cellule mémoire obtenue selon l'invention,
- la figure 3 représente en perspective une cellule mémoire obtenue selon le procédé de l'invention,
- les figures 4a à 4h sont des coupes suivant l'axe AA' de la figure 2, illustrant schématiquement les différentes étapes du procédé de fabrication d'un point mémoire EPROM selon l'invention,
- les figures 5, 6 et 7 illustrent respectivement des coupes suivant les axes BB′, CC′ et DD′ de la figure 2.

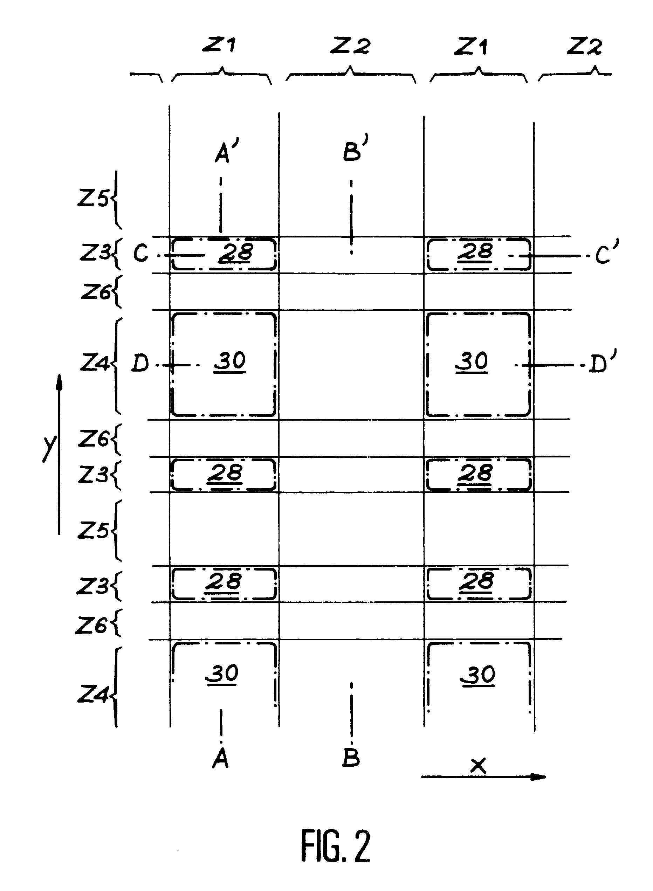

La figure 2 est une vue de dessus d'une cellule mémoire selon l'invention, qui montre la position des points mémoire et la position des trous de contact des drains de ces points mémoires.

La cellule mémoire est divisée suivant une direction X en bandes parallèles comprenant alternativement des bandes z₁ et des bandes z₂. Les bandes z₁ et z₂ n'ont pas nécessairement la même largeur. La cellule mémoire est également découpée suivant une direction Y perpendiculaire à la direction X, en quatre types de bandes z₃, z₄, z₅ et z₆. Les largeurs de ces bandes ne sont pas nécessairement égales. Ces bandes sont disposées, suivant la direction Y, selon le motif répété z₄, z₆, z₃, z₅, z₃ et z₆.

Chaque point mémoire comprend une source, un drain et au moins une grille. Cette grille est définie par la région 28 constituée par l'intersection des bandes z₁ et z₃. Les régions 30 constituées par l'intersection d'une bande z₁ et d'une bande z₄ correspondent aux trous de contact des drains des points mémoire. Le drain de chaque point mémoire est ainsi implanté sous la région définie par l'intersection entre une bande z₁ et une bande z₆. Enfin, la source de chaque point mémoire est implantée sous la région définie par l'intersection entre une bande z₁ et une bande z₅.

Dans la description qui suit, on se réfère, à titre d'exemple, à une cellule mémoire EPROM formée de points mémoire à canal N réalisés sur un substrat en silicium monocristallin de type p. Cependant, l'invention n'est nullement limité au mode de réalisation décrit mais s'applique au contraire à tous types de mémoire (ROM, EPROM, EEPROM ou autres) réalisées sur un substrat semiconducteur quelconque.

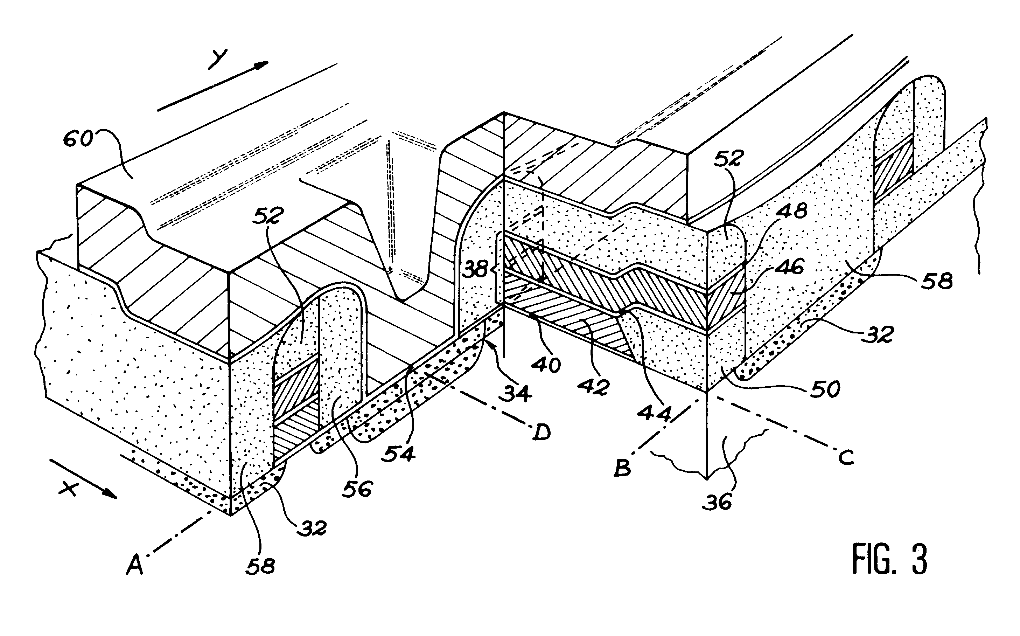

La cellule mémoire EPROM, représentée sur la figure 3, comporte, comme les cellules mémoires de l'art antérieur, une matrice de points mémoire comportant chacun une source 32 et un drain 34 de type n⁺ réalisé dans un substrat 36 en silicium monocristallin de type p. Des empilements 38 de matériaux sont prévus entre les sources et les drains.

Ces empilements 38, en partant du substrat 36, sont formés d'un premier isolant 40 en oxyde de silicium, d'une grille flottante 42 en silicium polycristallin dopée au phosphore, d'un second isolant 44 formé de trois matériaux isolants empilés SiO₂, Si₃N₄ et SiO₂, d'une grille de commande 46 en silicium polycristallin dopé au phosphore, et éventuellement d'une couche d'oxyde de silicium 48.

Afin d'isoler électriquement les uns des autres les points mémoire successifs selon la direction X, on prévoit des isolations latérales 50 réalisées en matériau isolant, tel que par exemple un oxyde de silicium.

Selon l'invention, la largeur des grilles des points mémoire, c'est-à-dire l'extension de ces grilles selon la direction Y, est définie par un espaceur 52. Ces espaceurs présentent la forme de bandes orientées selon la direction X. Ces espaceurs 52 servent de masque pour la gravure des grilles. Les flancs des grilles sont protégés par des matériaux isolants. Le flanc des grilles, du côté du drain 34, est isolé du trou de contact 54 par un matériau isolant 56, réalisé préférentiellement sous la forme d'un espaceur. De même, le flanc des grilles du côté de la source 32 est protégé par le dépôt d'une couche de matériau isolant 58.

Les points mémoire de la cellule mémoire sont organisés en matrice suivant les directions X et Y. Ils sont agencés en mots selon la direction X. Les points mémoire alignés suivant la direction X ont leurs grilles connectées entre elles par une ligne conductrice, qui est constituée par la couche 46 formant la grille de commande de chacun des points mémoire. La sélection d'un bit dans un mot est obtenue par une ligne conductrice 60, dite ligne de bit, qui relie entre eux les drains 34 alignés suivant la direction Y par l'intermédiaire des trous 54.

La cellule mémoire obtenue selon le procédé de fabrication de l'invention représentée sur la figure 3 permet d'annuler le débordement Y1 de l'oxyde de champ 50 par rapport à la grille flottante 42 et de réduire fortement la garde isolante Y2 entre le contact de drain 54 et les empilements 38. Ce procédé permet en outre de supprimer, de manière connue, le débordement X1 de la grille flottante 42 ou de celui de l'oxyde de champ 50 et la garde isolante X2 entre le contact de drain 54 et l'oxyde de champ 50.

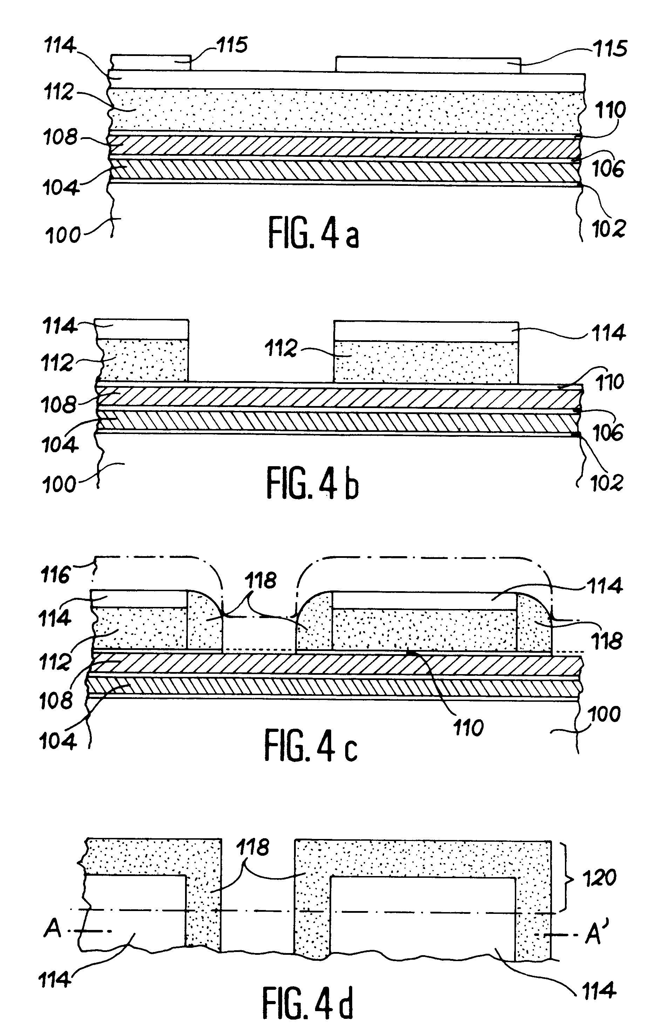

On va maintenant décrire, en référence aux figures 4a à 4h un procédé de fabrication d'une cellule mémoire conforme à l'invention, permettant d'obtenir une cellule mémoire telle que représentée sur la figure 3.

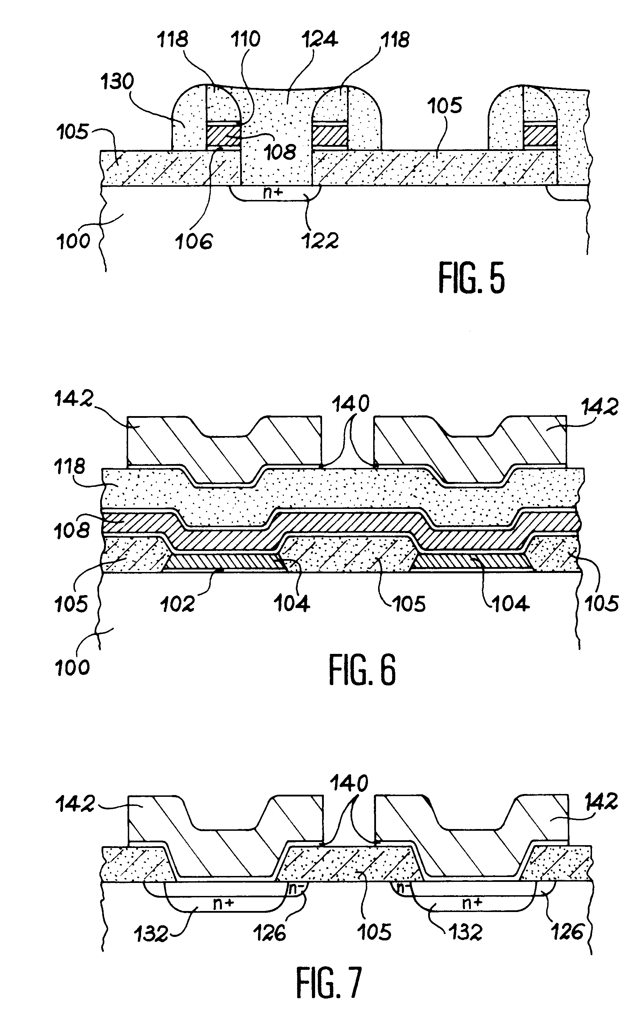

Le procédé de l'invention va être décrit principalement en référence aux figures 4a à 4h, qui représentent des coupes suivant l'axe AA′ de la cellule mémoire de la figure 2. On se réfèrera également accesionnellement aux figures 5, 6 et 7 qui correspondent respectivement à des coupes suivant les axes BB′, CC′ et DD′ de la figure 2.

Le procédé de fabrication comporte, comme on l'a déjà mentionné, quatre étapes, à savoir : une première étape de définition des grilles des points mémoire, une deuxième étape de réalisation des sources des points mémoire, une troisième étape de réalisation des drains des points mémoire et une quatrième étape de réalisation des lignes de bits.

Ce procédé consiste tout d'abord, comme représenté sur la figure 4a, à recouvrir un substrat semiconducteur 100 en silicium monocristallin, par exemple de type p, d'une couche 102 d'oxyde de silicium SiO₂. Cette couche 102 présente une épaisseur de 25 nanomètres et est obtenue par oxydation thermique du substrat, à une température voisine de 900°C. Cette couche 102 constituera ultérieurement l'oxyde de grille des points mémoire à réaliser.

On dépose ensuite une couche 104 de silicium polycristallin dopée au phosphore par diffusion de POCL₃. Cette couche 104 déposée par un procédé de dépôt chimique en phase vapeur (CVD ou LPCVD) présente une épaisseur de 250 nanomètres. Dans cette couche 104, sera réalisée ultérieurement la première grille, ou grille flottante, des points mémoire.

On utilise ensuite un premier masque de nitrure de silicium réalisé de manière classique par un dépôt suivi d'une gravure à travers un masque de lithographie. Ce premier masque est constitué de bandes z₁ (cf. figure 2) parallèles et alignées suivant la direction Y pour oxyder la couche 104, par exemple oxydation thermique à 900°C. On obtient ainsi des bandes z₂ (cf. figure 2) formant un isolant appelé oxyde de champ, qui permet d'isoler les points mémoire consécutifs alignés suivant la direction X.

Sur la figure 6 représentant une vue en coupe de la cellule mémoire de la figur 2 suivant l'axe CC′, on voit apparaître, en coupe transversale, les bandes z₁ constituées par les matériau 102 et 104, et les bandes z₂ constituées par le matériau 105, résultant de l'oxydation du matériau 104. On note que les bandes 104 et 105 sont autoalignées, c'est-à-dire que le recouvrement X1 et la garde isolante X2 qui étaient nécessaires dans les cellules mémoires selon l'art antérieur représenté sur la figure 1, sont ici supprimés.

Revenons à la figure 4a. Sur la couche 104, on réalise une couche 106 d'isolant diélectrique. Celui-ci est constitué par exemple d'un empilement de trois couches, comprenant successivement une couche d'oxyde de silicium d'épaisseur 15 nanomètres réalisée par oxydation thermique de la couche 104, une couche de nitrure de silicium d'épaisseur 10 nanomètres déposée par LPCVD et une couche d'oxyde de silicium d'épaisseur 5 nanomètres obtenue par oxydation de la couche de nitrure de silicium. Les deux dernières couches de nitrure et d'oxyde de silicium sont réalisées en même temps sur la couche 105. Dans la suite du texte , la référence numérique 106 désignera la couche constituée par l'ensemble desdites couches. Sur cette couche, on dépose ensuite une couche conductrice 108 dans laquelle sera réalisée la grille de commande de chaque point mémoire. Cette couche 108 peut être réalisée en silicium polycristallin dopé, ou en silicium polycristallin recouvert d'une couche de siliciure.

Les opérations qui ont été décrites jusqu'ici sont connues et sont mentionnées notamment dans l'article "SEPOX compatible high Density Floating Gate EPROM Structure", de N. Matsukawa et al, pages 108 et 109, publié dans VLSI Symposium, 198³.

La couche 108 est recouverte d'une couche d'oxyde 110, d'épaisseur 50 nanomètres, selon la technique de dépôt chimique en phase vapeur à basse pression (LPCVD).

Sur cette couche 110 on dépose une couche 112 de silicium polycristallin, d'épaisseur 800 nanomètres, et une couche 114 d'oxyde de silicium d'épaisseur 100 nanomètres. Les couches 112 et 114 sont déposées par exemple par la technique LPCVD. Les couches 112 et 114 vont servir, conformément à l'invention, à protéger les zones dans lesquelles seront réalisés les drains des points mémoire, lors de la gravure des couches déposées au-dessus des futures sources de ces points mémoire. Les gravures des grilles côté source et côté drains sont ainsi rendues indépendantes.

On utilise ensuite un deuxième masque de lithographie, constitué de bandes de résine 115, correspondant aux bandes z₄ sur la figure 2, pour graver par gravure ionique réactive les couches 112 et 114. Le masque de résine permet ainsi de protéger les zones dans lesquelles les drains des points mémoire seront implantés. Les gravures des couches 114 et 112 sont obtenues respectivement à l'aide d'un plasma CHF₃ et d'un plasma SF₆. Ces gravures n'affectent pas la couche 110.

Après l'élimination du deuxième masque de résine 115, la cellule mémoire se présente en vue de coupe suivant l'axe AA′ comme représenté sur la figure 4b.

L'opération suivante constitue la dernière opération de l'étape de définition des grilles des points mémoire. Elle consiste à réaliser des masques pour la gravure des grilles, ces masques étant constitués par des espaceurs.

La réalisation de ces espaceurs va être décrite en référence à la figure 4c.

Pour réaliser ces espaceurs, on dépose une couche d'oxyde de silicium 116, par exemple par LPCVD, que l'on grave de manière anisotrope, par exemple par une gravure ionique réactive qui élimine également la couche 110. Les espaceurs obtenus ont une largeur égale à l'épaisseur de la couche 116.

Le fait de définir les dimensions des grilles par des espaceurs est avantageuse car cela permet de réaliser des grilles submicroniques avec un excellent contrôle dimensionnel, ceci sans utiliser des outils de lithographie très performants. Il faut noter en particulier que le masque, constitué par ces espaceurs 118, qui sert à définir la position des grilles et qui est donc utilisé pour graver les couches 112 et 114, nécessite une résolution beaucoup plus faible que la dimension des motifs réalisés. Il faut noter également que le deuxième masque de résine 115 est constitué de bandes dont le pas est égal au double du pas des cellules mémoire. Ceci présente l'avantage de faire des cellules mémoires plus petites avec une résolution donnée de la lithographie.

L'obtention de grilles ayant une largeur submicronique présente également l'avantage que l'écriture dans les points mémoire peut être faite à une tension électrique de 5 volts, au lieu de 10 ou 12 volts utilisé actuellement, car dans les canaux submicroniques les électrons chauds sont engendrés à des tensions plus faible.

La figure 4d est une vue de dessus montrant les bandes 114 entourées par un cordon constitué par l'espaceur 118. Pour éviter que deux points mémoire situés de part et d'autre d'une même bande 114 ne soit en court-circuit, il convient d'éliminer la partie de l'espaceur 118 située à l'extrémité de chaque bande 114. On utilise donc un troisième masque de lithographie permettant de supprimer l'espaceur 118 dans la zone 120, cette élimination étant réalisée par exemple par une gravure chimique à l'acide fluorhydrique (HF). Aprés cette étape, on obtient des espaceurs en bandes correspondants aux bandes z₃ de la figure 2.

La première étape du procédé de l'invention, consistant à définir les grilles des points mémoire, est terminée. En effet, ces grilles sont définies suivant la direction X (cf. figure 2) par la largeur des bandes 104 (cf. figure 6) et selon les directions Y par la largeur des espaceurs 118 de la figure 4c.

Les opérations suivantes consistent réaliser les sources et les drains des points mémoire. Conformément à l'invention, on procède en deux étapes consécutives et indépendantes pour la réalisation successive des sources et des drains.

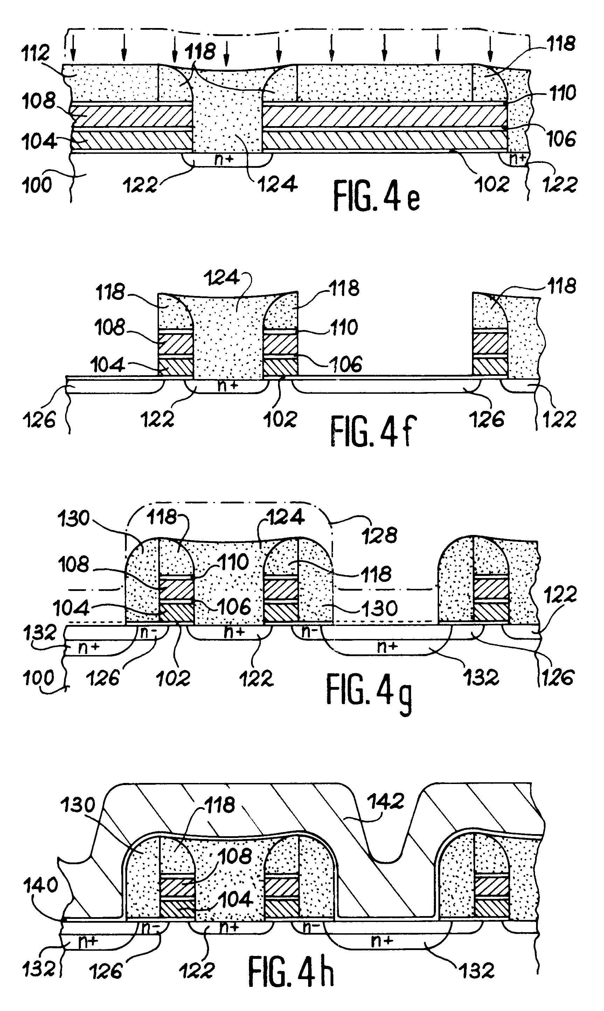

On va décrire en référence à la figure 4e la deuxième étape du procédé de l'invention, consistant réaliser 1es sources des points mémoire. Cette deuxième étape comprend une première opération de gravure des couches successives 108, 106, 104, 105 et 102 des zones qui ne sont pas protégées par les couches 114 ou 118. Les couches qui sont ainsi gravées correspondent aux bandes z₅ de la figure 2. Ces couches sont gravées de manière anisotrope, par gravure ionique réactive. On utilise respectivement un plasma de SF₆, CHF₃, SF₆ et CHF₃ pour les couches 108, 106, 104 et, 105 et 102.

On procède ensuite au dopage du substrat 100 mis à nu par la gravure. Dans le cas d'un substrat de silicium de type p, ce dopage 122 peut être réalisé en implantant des ions d'arsenic à une dose de 5x10¹⁵ at/cm² avec une énergie de 100 keV. On effectue alors un traitement thermique, par exemple 850°C pendant 30 minutes pour activer électriquement les ions implantés dans le substrat 100. On effectue ensuite le dépôt d'une couche d'isolant, par exemple du BPSG par dépôt chimique en phase vapeur (CVD), sur une épaisseur de 800 nanomètres. On effectue ensuite un fluage de cette couche d'isolant, par exemple à 900°C pendant 20 minutes afin d'obtenir une surface plane. Puis on grave la couche isolante et la couche 114 pour mettre à nu la couche 112.

La couche d'isolant 124 se présente alors sous la forme d'un ensemble de bandes parallèles, correspondant aux bandes z₅ de la figure 2, ce qui protége les sources 122 et permet d'entreprendre la gravure des couches 112.

Comme on l'a représenté sur la figure 4f, la gravure des couches 112 et des couches 110, 108, 106 et 104 protégées par cette couche 112, est effectuée pour permettre la réalisation des drains des points mémoire. Les couches 112, 110, 108, 106 et 104 sont gravées de manière anisotrope par gravure ionique réactive, les gravures des couches successives étant réalisées respectivement à l'aide de plasma de SF₆, CHF₃, SF₆, CHF₃, SF₆. Il faut noter que la gravure de la couche 104 n'entraîne pas la gravure des couches 105 et 102 (cf. figures 5 et 6).

Cette couche 105 permet d'isoler électriquement les drains entre eux.

Le procédé de l'invention, qui consiste à séparer les opérations de réalisation des sources et des drains des points mémoire, présentent l'avantage de permettre un dopage différent des sources et des drains. Ainsi, à titre d'exemple, on réalise une double implantation ionique pour la réalisation des drains alors que l'on a réalisé une simple implantation ionique pour la réalisation des sources.

Ces différences d'implantation peuvent être mise à profit dans le cas d'une cellule mémoire EPROM pour utiliser la source comme un drain au moment de l'écriture.

Comme représenté sur la figure 4f, on réalise un premier dopage 126 en implantant des ions phosphore à une dose de 2x10¹³ at/cm² avec une énergie de 40 keV.

On isole ensuite les grilles côté drain par le dépôt d'une matériau isolant. De manière préférée, comme représenté sur la figure 4g, ce matériau isolant prend la forme d'un espaceur. Pour l'obtenir, on dépose une couche d'oxyde de silicium 128 d'épaisseur 400 nanomètres. On grave ensuite cette couche de manière anisotrope par une gravure ionique réactive à plasma de CHF₃. On obtient ainsi les espaceurs 130.

On peut procéder ensuite à un deuxième dopage 132 des drains par implantation d'ions arsenic à une dose de 5x10¹⁵ at/cm² avec une énergie de 100 kev. On effectue ensuite un traitement thermique par exemple à 900°C pendant 30 minutes, pour activer électriquement les ions implantés.

Il ne reste qu'alors plus qu'à procéder à la quatrième étape du procédé de fabrication de l'invention qui consiste à réaliser les lignes conductrices pour la sélection des points mémoire.

Pour l'adressage des points mémoire, on utilise un premier ensemble de lignes conductrices parallèles alignées suivant la direction X et un deuxième ensemble de lignes conductrices parallèles alignées suivant la direction Y. Les lignes conductrices parallèles à la direction X sont des lignes de mots car elles permettent d'adresser simultanément les points mémoire correspondants aux différents bits d'un même mot binaire. Comme on peut le voir notamment sur la figure 3, ces lignes de mots sont constituées par les couches 46 formant les grilles de commande des différents points mémoire. Ces lignes de mots sont visibles en coupe transversale sur les figures 4f à 4h, dans lesquelles elles portent la référence numérique 108.

Les lignes de bits sont obtenues, comme représenté sur la figure 4h, par un premier dépôt d'une couche métallique 140 formée par exemple de TiN et d'un second dépôt d'une couche d'aluminium 142 sur une épaisseur de 800 nanomètres. Cette couche d'aluminium peut être déposée par pulvérisation magnétique.

On utilise ensuite un quatrième masque de lithographie pour définir les lignes de bits. Ce masque est constitué de bandes recouvrant les bandes z₁ (figure 2) et légèrement plus larges que celles-ci. On procède ensuite à une gravure anisotrope de type ionique réactive en utilisant du tétrachlorure de carbone comme agent d'attaque. On obtient ainsi des lignes conductrices dont la coupe transversale se présente comme montré sur les figures 6 et 7.

Pour alimenter les différents points mémoire, on peut connecter les sources à une ligne d'alimentation qui serait réalisée tous les N points mémoire (N=16 ou 32 par exemple) comme une ligne de bit décrite précédemment. Les drains connectés par cette ligne sont alors court-circuités avec les sources des points mémoire correspondants par un dopage commun réalisé par l'intermédiaire d'une implantation ionique à travers un masque approprié avant toute autre opération de réalisation des points mémoire.

## Revendications

1. Procédé de fabrication d'une cellule de mémoire intégrée sur un substrat semiconducteur (100) comportant une matrice de points mémoire isolés électriquement les uns des autres, chaque point mémoire comprenant un drain, une source, une grille et une ligne de commande de grille, ledit procédé comprenant les étapes suivantes :
a) une première étape de définition des grilles des points mémoire et de leur ligne de commande comprenant les opérations suivantes :
- a1) réalisation d'un empilement de matériaux dont l'un (104) au moins est conducteur et à la forme de premières bandes parallèles, alignées suivant une première direction (Y), pour réaliser une grille de points mémoire et dont un autre au moins est constitué d'une couche conductrice (108) pour réaliser les lignes de commande de grilles,
- a2) réalisation d'un ensemble de deuxièmes bandes parallèles, alignées suivant une seconde direction (X) perpendiculaire à la première direction (Y), lesdites bandes comprenant au moins une couche de matériau (112, 114),
- a3) réalisation d'espaceurs (118) sur chaque flanc desdites deuxièmes bandes, lesdits espaceurs formant des bandes suivant ladite seconde direction, lesdites grilles étant définies par les zones de superposition desdits espaceurs et desdites premières bandes et lesdites lignes de commande étant définies par lesdits espaceurs,
b) une deuxième étape de réalisation des sources des points mémoire comprenant les opérations suivantes :
- b1) gravure des couches non protégées par les espaceurs ou les matériaux constituants les deuxièmes bandes,
- b2) dopage (122) du substrat mis à nu par ladite gravure,
- b3) dépôt d'un matériau isolant (124) sur les zones dopées,
c) une troisième étape de réalisation des drains des points mémoire comprenant les opérations suivantes :
- c1) élimination par gravure des matériaux constituant les deuxièmes bandes,
- c2) élimination par gravure complère ou partielle des matériaux constituant l'empilement qui a été mis à nu lors de la gravure précédente,
- c3) dopage (126, 132) du substrat dans les régions gravées dans l'étape précédente,
- c4) isolation (130) des flancs des grilles mis à nu par les gravures précédentes,
d) une quatrième étape de réalisation de lignes conductrices (140, 142) parallèles, alignées suivant la première direction, lesdites lignes conductrices étant reliées électriquement au drain des points mémoires.

2. Procédé de fabrication selon la revendication 1, caractérisé en ce que les espaceurs réalisés au cours de la première étape sont obtenus de la manière suivante :
- dépôt d'une couche de matériau isolant (116) sur la surface totale du substrat semiconducteur,
- gravure anisotrope de ladite couche isolante sur toute son épaisseur.

3. Procédé de fabrication selon l'une quelconque des revendications 1 et 2, caractérisé en ce que le matériau (104) de l'empilement dans lequel les grilles seront obtenues est réalisé sous forme de premières bandes par oxydation localisée d'une couche de silicium polycristallin dopé à travers un masque, les zones oxydées constituant un ensemble de troisièmes bandes parallèles formant un oxyde de champ.

4. Procédé de fabrication selon l'une quelconque des revendications 1 à 3, caractérisé en ce que l'isolation du flanc des grilles au cours de la troisième étape est obtenue par un espaceur (130), réalisé dans un matériau isolant.

5. Procédé de fabrication selon la revendication 4, caractérisé en ce que ledit espaceur est obtenu de la manière suivante :
- dépôt d'une couche de matériau isolant (128) sur la surface totale du substrat semiconducteur,
- gravure anisotrope de ladite couche de matériau isolant.

6. Procédé de fabrication d'une cellule de mémoire EPROM selon la revendication 1, caractérisé en ce que l'empilement est constitué par une première couche (102) d'un oxyde de grille, une deuxième couche (104) de matériau conducteur, dans laquelle seront gravées des grilles des points mémoire, lesdites première et deuxième couches formant lesdites premières bandes, une troisième couche (106) de matériau isolant, une quatrième couche (108) de matériau conducteur, dans laquelle seront gravées les lignes de commande des points mémoire, et une cinquième couche (118) de matériau isolant.

7. Procédé de fabrication d'une cellule de mémoire PROM selon la revendication 1, caractérisé en ce que l'empilement est constitué par une première couche (102) d'un oxyde de grille, une deuxième couche (104) de matériau conducteur, dans laquelle seront gravées les grilles des points mémoires, lesdites première et deuxième couches formant lesdites premières bandes, une troisième couche (108) de matériau conducteur dans laquelle seront gravées les lignes de commande des points mémoires, et une quatrième couche de matériau isolant.

8. Procédé de fabrication d'une cellule mémoire selon la revendication 1, caractérisé en ce que les dopages des drains et des sources sont différents.

9. Procédé de fabrication d'une cellule mémoire selon la revendication 8, caractérisé en ce que le dopage des drains comprend successivement une première implantation ionique et une seconde implantation ionique, la dose de la seconde implantation étant supérieure à la dose de la première implantation et les zones implantées au cours de la seconde implantation étant plus petites que celles implantées au cours de la première implantation.

## Claims

1. Process for the production of an integrated memory cell on a semiconductor substrate (100) having a matrix of memory points electrically insulated from one another, each memory point comprising a drain, a source, a gate and a gate control line, said process comprising the following stages:
a) a first stage of defining the gates of the memory points and their control line involving the following operations:
a1) producing a stack of materials, whereof at least one (104) is conductive and is in the form of first parallel strips aligned in a first direction (Y), for producing a gate of memory points and whereof at least one other is constituted by a conductive layer (108) for producing the control lines of the gates,
a2) producing a group of second parallel strips, aligned in a second direction (X) perpendicular to the first direction (Y), said strips having at least one insulating material layer (112, 114),
a3) producing spacers (118) on each flank of said second strips, said spacers forming strips in the second direction (X), said gates being defined by superimposing zones of said spacers and said first strips, the control lines being defined by the spacers,
b) a second stage of producing sources of memory points involving the following operations:
b1) etching layers not protected by spacers or by materials constituting the second strips,
b2) doping (122) the substrate exposed by said etching operation,
b3) deposition of an insulating material (124) on the doped zones,
c) a third stage of producing drains of memory points involving the following operations:
c1) elimination by etching of the materials constituting the second strips,
c2) elimination by complete or partial etching of the materials constituting the stack exposed during the previous etching operation,
c3) doping (126, 132) the substrate in the regions etched in the preceding stage,
c4) insulation (130) of the drain-side flanks of the gates exposed by the preceding etching operations,
d) a fourth stage of producing parallel conductive lines (140, 142), aligned in accordance with the first direction, said conductive lines being electrically connected to the drains of the memory points.

2. Production process according to claim 1, characterized in that the spacers produced during the first stage are obtained by depositing an insulating material layer (116) on the complete surface of the semiconductor substrate and anisotropically etching said insulating layer over its entire thickness.

3. Production process according to either of the claims 1 and 2, characterized in that the material (104) of the stack in which the gates will be obtained is produced in the form of first strips by local oxidation of a polycrystalline silicon layer doped through a mask, the oxidized zones constituting a group of three parallel strips forming a field oxide.

4. Production process according to any one of the claims 1 to 3, characterized in that the insulation of the flank of the gates during the third stage is obtained by a spacer (130) made from an insulating material.

5. Production process according to claim 4, characterized in that said spacer is obtained by depositing an insulating material layer (128) on the complete surface of the semiconductor substrate and anisotropically etching said insulating material layer.

6. Production process for an EPROM cell according to claim 1, characterized in that the stack is constituted by a first gate oxide layer (102), a second conductive material layer (104), in which will be etched the gates of the memory points, said first and second layers forming said first strips, a third insulating material layer (106), a fourth conductive material layer (108), in which will be etched the control lines of the memory points, and a fifth insulating material layer (118).

7. Production process of a PROM cell according to claim 1, characterized in that the stack is constituted by a first gate oxide layer (102), a second conductive material layer (104), in which will be etched the gates of the memory points, said first and second layers forming said first strips, a third conductive material layer (108), in which will be etched the control lines of the memory points, and a fourth insulating material layer.

8. Production process for a memory cell according to claim 1, characterized in that there are different dopings of the drains and sources.

9. Production process of a memory cell according to claim 8, characterized in that the dopings of the drains successively comprise a first ionic implantation and a second ionic implantation, the dose of the second implantation exceeding that of the first and the zones implanted during the second implantation are smaller than those implanted during the first implantation.

## Patentansprüche

1. Herstellungsverfahren für eine integrierte Speicherzelle auf einem Halbleitersubstrat (100), die eine Matrix von elektrisch voneinander isolierten Speicherelementen aufweist, wobei jedes Speicherelement ein Drain, eine Source, ein Gate und eine Steuerleitung für das Gate besitzt, wobei das Verfahren die folgenden Schritte umfaßt:
a) einen ersten Schritt zur Festlegung der Gates der Speicherelemente und ihrer Steuerleitung, der die folgenden Operationen umfaßt:
- a1) Erzeugung einer Schichtung von Materialien, von denen wenigstens das eine (104) leitend ist und die Form von ersten parallelen, in einer ersten Richtung (Y) ausgerichteten Streifen hat, um ein Gate der Speicherelemente zu erzeugen, und von denen wenigstens ein weiteres aus einer leitenden Schicht (108) zur Erzeugung der Steuerleitungen besteht,
- a2) Erzeugung einer Anordnung von zweiten parallelen, in einer zweiten, zur ersten Richtung (Y) senkrechten Richtung (X) ausgerichteten Streifen, wobei diese Streifen wenigstens eine Materialschicht (112, 114) umfassen,
- a3) Erzeugung von Abstandselementen (118) auf jeder Seite der zweiten Streifen, wobei diese Abstandselemente Streifen in der zweiten Richtung bilden, die Gates durch die Überlagerungsbereiche der Abstandselemente und der ersten Streifen definiert werden und die Steuerleitungen durch die Abstandselemente festgelegt werden,
b) einen zweiten Schritt zur Erzeugung der Sources der Speicherelemente, der die folgenden Operationen umfaßt:
- b1) Ätzen der schichten, die nicht durch die Abstandselemente oder die die zweiten Streifen bildenden Materialien geschützt sind,
- b2) Dotierung (122) des durch die Ätzung freigelegten Substrats,
- b3) Abscheidung eines isolierenden Materials (124) auf den dotierten Bereichen,
c) einen dritten Schritt zur Erzeugung der Drains der Speicherelemente, der die folgenden Operationen umfaßt:
- c1) Entfernung durch Ätzung der Materialien, die die zweiten Streifen bilden,
- c2) vollständige oder teilweise Entfernung durch Ätzung der Materialien, die die Schichtung bilden, die bei der vorangegangenen Ätzung freigelegt wurde,
- c3) Dotierung (126, 132) des Substrats in den im vorangegangenen Schritt geätzten Gebieten,
- c4) Isolierung (130) der Wände der Gates, die durch die vorangegangenen Ätzungen freigelegt wurden,
d) einen vierten Schritt zur Erzeugung von parallelen leitenden Leitungen (140, 142), die in der ersten Richtung ausgerichtet sind, wobei diese leitenden Leitungen elektrisch mit dem Drain der Speicherelemente verbunden sind.

2. Herstellungsverfahren nach Anspruch 1, dadurch gekennzeichnet, daß die im Verlauf des ersten Schritts erzeugten Abstandselemente in folgender Weise erhalten werden:
- Abscheidung einer Schicht isolierenden Materials (116) auf der gesamten Oberfläche des Halbleitersubstrats,
- anisotrope Ätzung der isolierenden Schicht über ihre gesamte Dicke.

3. Herstellungsverfahren nach einem der Ansprüche 1 und 2, dadurch gekennzeichnet, daß das Material (104) der Schichtung, in dem dann die Gates erhalten werden, durch lokalisierte Oxidation einer Schicht polykristallinen, über eine Maske dotierten Siliciums in Form erster Streifen erzeugt wird, wobei die oxidierten Zonen eine Anordnung von dritten parallelen Streifen darstellen, die ein Feldoxid bilden.

4. Herstellungsverfahren nach einem der Ansprüche 1 bis 3, dadurch gekennzeichnet, daß die Seitenisolation der Gates im Verlauf des dritten Schritts durch ein Abstandselement (130) erhalten wird, das aus einem isolierenden Material erzeugt wird.

5. Herstellungsverfahren nach Anspruch 4, dadurch gekennzeichnet, daß das Abstandselement auf die folgende Weise erhalten wird:
- Abscheidung einer Schicht isolierenden Materials (128) auf der gesamten Oberfläche des Halbleitersubstrats,
- anisotrope Ätzung dieser Schicht isolierenden Materials.

6. Herstellungsverfahren für eine EPROM-Speicherzelle nach Anspruch 1, dadurch gekennzeichnet, daß die Schichtung aus einer ersten Schicht (102) eines Gateoxids, einer zweiten Schicht (104) aus leitendem Material, in der dann die Gates der Speicherelemente geätzt werden, wobei die erste und die zweite Schicht die ersten Streifen bilden, einer dritten Schicht (106) aus isolierendem Material, einer vierten Schicht (108) aus leitendem Material, in die dann die Steuerleitungen der Speicherelemente geätzt werden, und einer fünften Schicht (118) aus isolierendem Material besteht.

7. Herstellungsverfahren für eine PROM-Speicherzelle nach Anspruch 1, dadurch gekennzeichnet, daß die Schichtung aus einer ersten Schicht (102) eines Gateoxids, einer zweiten Schicht (104) aus leitendem Material, in der dann die Gates der Speicherelemente geätzt werden, wobei die erste und die zweite Schicht die ersten Streifen bilden, einer dritten Schicht (108) aus leitendem Material, in die dann die Steuerleitungen der Speicherelemente geätzt werden, und einer vierten Schicht aus isolierendem Material besteht.

8. Herstellungsverfahren für eine Speicherzelle nach Anspruch 1, dadurch gekennzeichnet, daß die Dotierungen der Drains und der Sources verschieden sind.

9. Herstellungsverfahren für eine Speicherzelle nach Anspruch 8, dadurch gekennzeichnet, daß die Dotierung der Drains nacheinander eine erste Ionenimplantation und eine zweite Ionenimplantation umfaßt, wobei die Dosis der zweiten Implantation höher ist als die Dosis der ersten Implantation und die im Verlauf der zweiten Implantation implantierten Bereiche kleiner als die im Verlauf der ersten Implantation implantierten Bereiche sind.
